# EUROPEAN PATENT SPECIFICATION

(11) **EP 4 567 877 B1**
(45) Date of publication and mention of the grant of the patent: **28.10.2026**
(21) Application number: 25171931.6
(22) Date of filing: 19.09.2018
(51) Int. Cl.: H05K 7/20, H05K 1/02, H10W 40/10, H01S 5/024

(54) **ELECTRICALLY INSULATING THERMAL CONNECTOR HAVING A LOW THERMAL RESISTIVITY**
ELEKTRISCH ISOLIERENDER THERMISCHER VERBINDER MIT NIEDRIGEM THERMISCHEM WIDERSTAND
CONNECTEUR THERMIQUE ÉLECTRIQUEMENT ISOLANT À FAIBLE RÉSISTIVITÉ THERMIQUE

(30) Priority: 21.09.2017 US 201762561408 P
(43) Date of publication of application: 11.06.2025
(62) Document number(s) of the earlier application(s) in accordance with Art. 76 EPC: 18859707.4 / 3 685 643
(73) Proprietor: KYOCERA AVX Components Corporation, Fountain Inn, SC 29644 (US)
(72) Inventor: DURGIN, Scott B., Fountain Inn, 29644 (US)
(74) Representative: dompatent

(56) References cited:
- EP-A1- 3 168 868
- JP-A- 2000 261 271
- JP-A- 2012 239 116
- JP-A- 2017 143 227
- US-A1- 2016 099 109
- US-A1- 2017 164 510
- ANONYMOUS: "ThermaBridge(TM) Specialty Thick Film Component | IMS", 24 May 2017 (2017-05-24), pages 1 - 4, XP055804665, Retrieved from the Internet <URL:https://ims-resistors.com/thermabridge-specialty-thick-film-component/> [retrieved on 20210517]

## Description

Electrical circuits, such as power amplifier circuits, generate heat during normal operation. Heat build-up may undesirably increase the temperature of the various components of the electrical circuit. If this heat is not sufficiently managed, for example by dissipation to a heat sink, the electrical device may overheat, resulting in damage to the electrical component. Connecting an electrical component directly to the heat sink, however, may undesirably create an electrical connection between the electrical component and the heat sink, i.e., a flow of electrical current, and disrupt the operation of the electrical component and circuit. As such, a need currently exists for a thermal connector having a low thermal resistance and a high electrical resistance.

ThermaBridge^{™} is a specialty thick film component developed and offered by IMS for use in the thermal management of electronic devices and modules. These products operate under the principle of conducting heat energy, while simultaneously serving as an insulator of electrical energy and signal.

EP3168868A1 discloses a thermal management system and method for electronic devices. The system includes an electronic device, a heat sink, and a thermally conducting and electrically insulating thermal bridge that is interposed between the electronic device and the heat sink. The thermal bridge thermally couples the electronic device to the heat sink and electrically isolates the electronic device from the heat sink. The electronic device, the heat sink, and the thermal bridge are mounted on a same planar surface of a printed circuit board.

US20170164510A1 discloses a thermal bridge including a first plate stack, a second plate stack and a temperature responsive actuator. The first plate stack is placed in thermal communication with a first electrical component and has a plurality of first plates. The second plate stack is placed in thermal communication with a second electrical component and has a plurality of second plates interleaved with the first plates. The temperature responsive actuator is coupled to at least one of the first and second plate stacks. The temperature responsive actuator changes shape based on changes in temperature to change the relative positions of the first and second plates. The temperature responsive actuator causes the first and second plates to vary thermal resistance between the first and second electrical components based on the change in relative positions of the first and second plates.

JP2017143227 A discloses a constant voltage generation circuit including: an ED type reference voltage source for generating a predetermined constant voltage Vreg by using a depression type first transistor and an enhancement type second transistor serially connected between a power supply end and a ground end; and a third transistor whose source is connected to the output end of the constant voltage Vreg, and whose drain is connected to the power source end, and whose gate is connected to a connection node between the first transistor and the second transistor.

US2016099109A1 discloses a film capacitor including a stacked body formed by stacking metalized films in each of which a metal electrode is formed on a surface of a dielectric film, at least one of the dielectric films containing a high thermal conductive filler; and external electrodes formed at electrode forming ends provided at opposed positions in the stacked body.

JP2000261271A discloses capacitor electrodes constituting a first capacitor C1, and capacitor electrodes constituting a second capacitor.

### Summary of the Invention

The invention is set out in the independent claims. Preferred embodiments are reflected in the dependent claims.

The present invention provides a thermal connector comprising:
an electrically insulating beam having a first end face at a first end and a second end face at a second end, the second end face opposite the first end face in an X direction, the electrically insulating beam having a width in a Y direction perpendicular to the X direction, the electrically insulating beam having a top face and a bottom face which is offset from the top face in a Z direction, the Z direction being perpendicular to each of the X and Y directions;
a first terminal attached to the bottom face and adjacent the first end;
a second terminal attached to the top face and adjacent the first end; and
a conductive trace formed on an outer surface of the electrically insulating beam and configured to provide electrical tuning.

In accordance with one embodiment of the present invention, a thermal connector is disclosed. The thermal connector includes an electrically insulating beam having a first end face at a first end and a second end face at a second end. The second end face is opposite the first end face in an X direction. The electrically insulating beam has a width in a Y direction which is perpendicular to the X direction. The electrically insulating beam also has a top face and a bottom face offset from the top face in a Z direction, which is perpendicular to each of the X and Y directions. The thermal connector includes a first terminal attached to the bottom face and adjacent the first end and a second terminal attached to the top face and adjacent the first end. The connector may have an overall thickness in the Z direction, which includes the first and second terminals. The overall thickness may be greater than 0.05 inch (1.27 mm) and less than 0.15 inch (3.81 mm).

### Brief Description of the Drawings

A full and enabling disclosure of the present invention, including the best mode thereof, directed to one of ordinary skill in the art, is set forth more particularly in the remainder of the specification, which makes reference to the appended figure in which:
FIG. 1 is a perspective view of one embodiment of a thermal connector in accordance with aspects of the present invention;
FIG. 2 is a perspective view of another embodiment of the thermal connector in accordance with aspects of the present invention;
FIG. 3 is a perspective view of the embodiment of the thermal connector illustrated in FIG. 1 connecting an electronic device with a heat sink;
FIG. 4 is a perspective view of the embodiment of the thermal connector illustrated in FIG. 2 connecting an electronic device with a heat sink;
FIG. 5 is a perspective view of the embodiment of the thermal connector illustrated in FIG. 1 connecting an electronic device with a heat sink;
FIG. 6A is a perspective view of an embodiment of the thermal connector that includes conductive traces configured to provide electrical tuning;
FIG. 6B is a perspective view of another embodiment of the thermal connector that includes conductive traces configured to provide electrical tuning;
FIG. 7 is a perspective view of an embodiment of the thermal connector having holes formed therein to provide electrical tuning; and
FIG. 8 is a perspective view of an example of an electrical component, a laser diode.

Repeat use of reference characters in the present specification and drawing is intended to represent same or analogous features or elements of the invention.

### Detailed Description of Representative Embodiments

Generally speaking, the present invention is directed to a thermal connector which may be connected between an electrical component and a heat sink, or other thermal point, to improve heat dissipation from the electrical component to the heat sink. The thermal connector may have one or more terminals at each end to aid with connection to the heat sink and electrical component. The terminals may be electrically separate and the beam may have a high electrical resistance such that a flow of electrical current between the terminals may be prevented or substantially prevented. This configuration may be advantageous because it may dissipate heat from the electrical component to the heat sink without electrically connecting the component to the heat sink, which might disrupt the operation of the component.

### I. Thermal Connector with Non-Wrapped Terminals

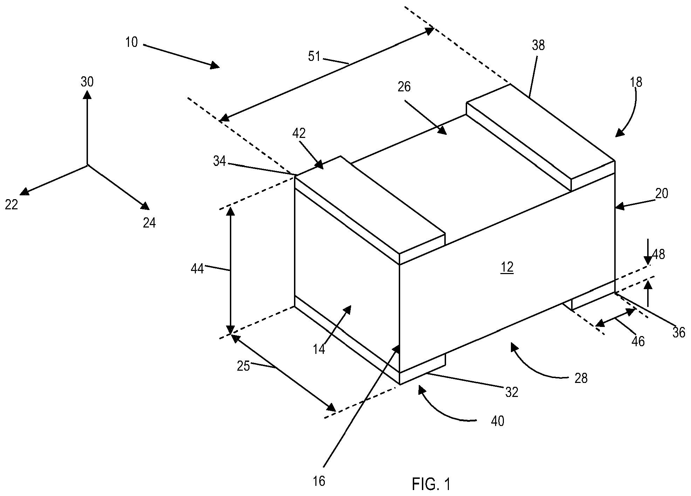

Referring to FIG. 1, the thermal connector 10 includes an electrically insulating beam 12 having a first end face 14 at a first end 16 and a second end face 18 at a second end 20. The second end face 18 is opposite the first end face 14 in an X direction 22. In some embodiments, the first end face 14 may be parallel with the second end face 18. The electrically insulating beam 12 has a width in a Y direction 24 which is perpendicular to the X direction 22. In some embodiments, the width of the electrically insulating beam 12 may be equal to an overall width 25 of the thermal connector 10. The electrically insulating beam 12 also has a top face 26 and a bottom face 28. The bottom face 28 is offset from the top face 26 in a Z direction 30, which is perpendicular to each of the X and Y directions 22, 24. In some embodiments, the top and bottom faces 26, 28 of the electrically insulating beam 12 may be parallel. The thermal connector 10 may include a first terminal 32 attached to the bottom face 28 of the electrically insulating beam 12 and adjacent the first end 16. The thermal connector 10 includes a second terminal 34 attached to the top face 26 and adjacent the first end 16 of the electrically insulating beam 12.

Still referring to FIG. 1, in some embodiments, the thermal connector 10 may have four terminals. For example, in addition to the first and second terminals 32, 34, discussed above, the thermal connector 10 may include a third terminal 36 attached to the bottom face 28 of the electrically insulating beam 12 and adjacent the second end 20. The thermal connector 10 may also include a fourth terminal 38 attached to the top face 26 and adjacent the second end 20.

Each terminal may extend to a respective edge adjacent a respective end face. For example, the first terminal 32 may extend on the bottom face 28 of the electrically insulating beam 12 along an edge between the bottom face 28 of the electrically insulating beam 12 and the first end face 14 of the electrically insulating beam 12. The second terminal 34 may extend on the top face 26 of the beam 12 along an edge between the top face 26 and first end face 14 of the electrically insulating beam 12. Similarly, the third terminal 36 may extend on the bottom face 28 of the electrically insulating beam 12 along an edge between the second end face 18 and the bottom face 28 of the electrically insulating beam 12. Lastly, the fourth terminal 38 may extend on the top face 26 of the electrically insulating beam 12 along an edge between the top face 26 and the second end face 18 of the electrically insulating beam 12.

The first terminal 32 may have a bottom surface 40 parallel with the bottom face 28 of the electrically insulating beam 12, and the second terminal 34 may have a top surface 42 parallel with the top face 26 of the electrically insulating beam 12. An overall thickness 44 of the connector may be defined as a distance between the bottom surface 40 of the first terminal 32 and the top surface 42 of the second terminal 34 in the Z direction 30, for example. In some embodiments, however, the thermal connector 10 may not include the second and/or fourth terminals 34, 38 on the top face 26 of the electrically insulating beam 12. In such an embodiment, the overall thickness 44 may be defined as the distance between the bottom surface 40 of the first terminal 32 and the top face 26 of the electrically insulating beam 12 in the Z direction 30.

Each of the terminals may have a respective terminal length 46 in the X direction 22 and a respective terminal thickness 48 in the Z direction 30 (labeled in FIG. 1 for the third terminal 36 only for clarity). The overall thickness 44 of the thermal connector 10 in the Z direction 30 may include the respective thicknesses of the terminals in the Z direction 30.

In some embodiments, the thermal connector 10 may have an overall length 51 in the Y direction 24. The overall length 51 and overall width 25 of the thermal connector 10 may be equal to the length and width, respectively, of the electrically insulating beam 12, as illustrated in FIG. 1. For example, the terminals may not extend beyond the edges of the top and bottom faces 26, 28. In other embodiments, however, one or more of the terminals may extend beyond the respective edges of the top and/or bottom face 26, 28 of the electrically insulating beam 12. In that case, the overall length 51 and/or overall width 25 of the thermal connector 10 may be larger than the respective length and and/or width of the electrically insulating beam 12. This may advantageously provide a larger terminal to connect an electrical component and/or heat sink to the thermal connector 10.

### II. Thermal Connector with Wrapped Terminals

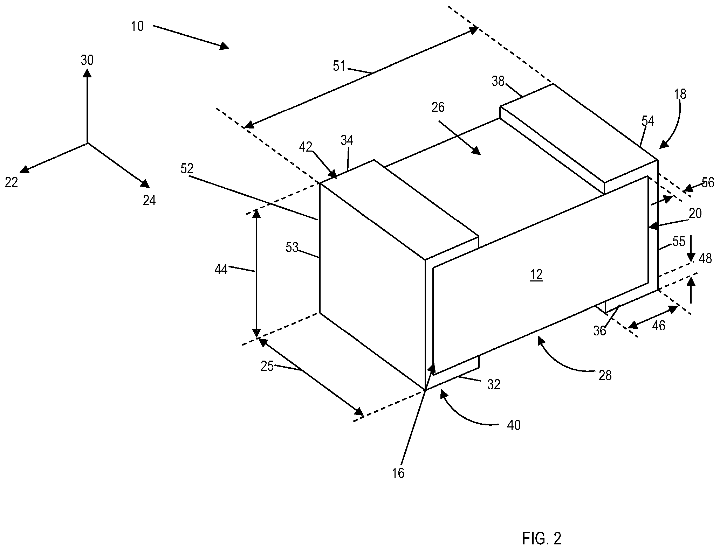

Referring to FIG. 2, in some embodiments, the thermal connector 10 may include a first wrap-around terminal 52 which wraps, or extends, around the first end 16 of the electrically insulating beam 12 such that the first wrap-around terminal 52 is attached to both the top face 26 of the electrically insulating beam 12 and the bottom face 28 of the electrically insulating beam 12. The first wrap-around terminal 52 may include a first terminal 32 and a second terminal 34, similar to the previous embodiment, and may also include a first end face terminal 53. The first end face terminal 53 may connect the first terminal 32 with the second terminal 34 and may be attached to the first end face 14 (shown in FIG. 1) of the electrically insulating beam 12. In one embodiment, the first wrap-around terminal 52 may be a single continuous terminal. For example, the first terminal 32, second terminal 34, and the first end face terminal 53 may be portions of the first wrap-around terminal 52. Additionally, the first wrap-around terminal 52 may be formed using any suitable technique, and may be formed in a single step, for example.

A second wrap-around terminal 54 may be similarly configured such that the second wrap-around terminal 54 wraps around the second end 20 of the electrically insulating beam 12 and is attached to both the top face 26 of the electrically insulating beam 12 and the bottom face 28 of the electrically insulating beam 12. For example, the second wrap-around terminal 54 may include a third terminal 36 and a fourth terminal 38, similar to the previous embodiment, and may additionally include a second end face terminal 55. The second end face terminal 55 may be attached to the second end face 18 (shown in FIG. 1) of the electrically insulating beam 12 and may connect the third terminal 36 with the fourth terminal 38. In one embodiment, the second wrap-around terminal 54 may be a single continuous terminal. For example, the third terminal 36, fourth terminal 38, and the second end face terminal 55 may be portions of the second wrap-around terminal 54. Additionally, the second wrap-around terminal 54 may be formed using any suitable technique, and may be formed in a single step, for example.

In some embodiments, the first wrap-around terminal 52 may span the width of the electrically insulating beam 12 across the first end face 14 of the electrically insulating beam 12 such that the width of the electrically insulating beam 12 is equivalent to the overall width 25 of the connector 10. The second wrap-around terminal 54 may similarly span the width of the electrically insulating beam 12 across the second end face 18 of the electrically insulating beam 12. For example, the first wrap-around terminal 52 may have a top surface 42 which is adjacent and/or parallel with the top face 26 of the electrically insulating beam 12. The first wrap-around terminal 52 may also have a bottom surface 40 which is adjacent and/or parallel with the bottom face 28 of the electrically insulating beam 12. The overall thickness 44 of the connector 10 may be defined as the distance in the Z direction 30 between the top surface 42 of the first wrap-around terminal 52 and the bottom surface 40 of the first wrap-around terminal.

Each of the terminals may have a respective terminal length 46 in the X direction 22 and terminal thickness 48 in the Z direction 30 (labeled only on the second wrap-around terminal 54 for clarity). In some embodiments, the portion of the first wrap-around terminal 52 attached to the top surface 42 may have a different length than the portion of the first wrap-around terminal 52 attached to the bottom face 28. In other embodiments, these lengths may be the same or similar as illustrated in FIG. 2.

The first and second wrap-around terminals 52, 54 may also have respective terminal thicknesses 56 in the X direction 22 along the first and second end faces 14, 18 of the electrically insulating beam 12 direction (labeled on the second terminal 54 only for clarity). In some embodiments, the terminal thickness 56 in the X direction 22 of the second wrap-around terminal 54 may be approximately equal to the terminal thickness 48 in the Z direction 30 of the second wrap-around terminal 54 such that the second wrap-around terminal 54 has a uniform thickness. In some embodiments, the first wrap-around terminal 52 may be similarly configured. In other embodiments, the terminal thickness 48 in the Z direction 30 may be different than the terminal thickness 56 in the X direction 22, for example.

Referring to FIG. 2, the overall length 51 of the thermal connector 10 may include each respective terminal thickness 56 in the X direction 22 of the first and second wrap-around terminals 52, 54. The thermal connector 10 may also have an overall width 25 in the X direction 22. In some embodiments, the overall width 25 of the thermal connector 10 may be equal to the width of the electrically insulating beam 12 because the respective widths of first and second wrap-around terminals 52, 54 may be equal to or less than the width of the electrically insulating beam 12. In other embodiments, however, the first and second wrap-around terminals 52, 54 may have respective widths greater than the width of the electrically insulating beam 12 such that at least one of first or second wrap-around terminals 52, 54 extend beyond an edge of the electrically insulating beam 12 in the Y direction 24. This may provide a larger terminal to connect the electrical component 60 and/or heat sink 62 to the thermal connector 10.

### III. Dimensions, Properties, and Materials

As noted above, the overall thickness 44 of the thermal connector 10 in the Z direction 30 may include the thicknesses 48 of the first and second terminals 32, 34 in the Z direction 30. In some embodiments, the overall thickness 44 of the thermal connector 10 may be greater than 0.05 inch (1.27 mm) and less than 0.15 inch (3.81 mm). For example, in some embodiments, the overall thickness 44 may be between about 0.055 inch (1.40 mm) and about 0.1 inch (2.54 mm), in other embodiments between about 0.055 inch (1.40 mm) and about 0.085 inch (2.16 mm), in other embodiments between about 0.056 inch (1.42 mm) and about 0.07 inch (1.78 mm), in other embodiments between about 0.057 inch (1.45 mm) and about 0.063 inch (1.60 mm). In some embodiments, the overall thickness 44 may be about 0.06 inch (1.52 mm) or greater. For instance, the thickness may be between about 0.06 inch (1.52 mm) and about 0.14 inch (3.556 mm), in other embodiments, between about 0.07 (1.78 mm) inch and about 0.13 inch (3.30 mm), in other embodiments, between about 0.08 inch (2.03 mm) and about 0.12 inch (3.05 mm), in other embodiments, between about 0.09 inch (2.29 mm) and about 0.11 inch (2.79 mm), and, in other embodiments, between about 0.1 inch (2.54 mm) and about 0.15 inch (3.81 mm).

**In** some embodiments, the overall length 51 of the thermal connector 10 may be between about 0.1 inch (2.54 mm) and about 0.5 inch (1.27 mm), and in some embodiments, between about 0.15 inch (3.81 mm) and about 0.25 inch (6.35 mm), and in some embodiments, between about 0.2 inch (5.08 mm) and about 0.4 inch (10.16 mm), and in some embodiments, between about 0.25 inch (6.35 mm) and about 0.45 inch (11.43 mm), and in some embodiments, between about 0.3 inch (7.62 mm) and about 0.4 inch (10.16 mm), and in some embodiments, between about 0.35 inch (8.89 mm) and 0.38 inch (9.65 mm).

**In** some embodiments, the overall width 25 of the thermal connector 10 may be between about 0.05 inch (0.25 mm) and about 0.4 inch (10.16 mm), and in some embodiments between about 0.02 inch (0.51 mm) about 0.4 inch (10.16 mm), and in some embodiments between about 0.08 inch (2.03 mm) and about 0.3 inch (7.62 mm), and in some embodiments between about 0.08 inch (2.03 mm) and about 0.1 inch (2.54 mm), and in some embodiments between about 0.2 inch (5.08 mm) and about 0.3 inch (7.62 mm), and in some embodiments between about 0.3 inch (7.62 mm) and about 0.4 inch (10.16 mm).

**In** some embodiments, the overall length 51 of the thermal connector 10 may be between about 1 and about 6 times greater than the overall thickness 44 of the thermal connector 10, in some embodiments, between about 2 and about 6 times greater than the overall thickness 44 of the thermal connector 10, and, in some embodiments, between about 2 and about 3.5 times greater than the overall thickness 44 of the thermal connector 10.

**In** other embodiments, the overall length 51 of the thermal connector 10 may be between about 3.2 and about 4.9 times greater than the overall thickness 44 of the thermal connector 10, and in some embodiments between about 3.5 and about 4.5 times greater than the overall thickness 44 of the thermal connector 10, and in some embodiments between about 3.8 and about 4.2 times greater than the overall thickness 44 of the thermal connector 10. In other embodiments, the overall length 51 of the thermal connector 10 may be between 5 and 6.2 times greater than the overall thickness 44 of the thermal connector 10, and in some embodiments between about 5.5 and 6.2 times greater than the overall thickness 44 of the thermal connector 10, and in some embodiments between about 6.0 and 6.2 times greater than the overall thickness 44 of the thermal connector 10.

In some embodiments, each of the overall length 51 and the overall width 25 of the thermal connector 10 may be between about 0.35 inch (8.89 mm) and about 0.4 inch (10.16 mm). For example, in some embodiments, each of the overall length 51 and the overall width 25 of the thermal connector 10 may be between about 0.36 inch (9.14 mm) and about 0.38 inch (9.65 mm).

In some embodiments, the thermal resistance across the overall length 51 of the thermal connector 10 may be between about 2 °C/W and about 10 °C/W at about 22 °C, and in some embodiments between 3 °C/W and about 7 °C/W at about 22 °C. For the embodiment depicted in FIG. 1, the thermal resistance may be associated with a heat flow between the first and third terminals 32, 36, for example. For the embodiment depicted in Fig 2, the thermal resistance may be associated with a heat flow between the first and second terminals 32, 34, for example.

In some embodiments, the thermal connector 10 may have an aspect ratio between the overall length 51 and the overall width 25 calculated as the length divided by the width. A "thermal aspect resistance" parameter may be defined as the ratio of the aspect ratio to the thermal resistance of the thermal connector 10 across the length of the thermal connector 10 (e.g., between the first and third terminals 32, 36 for the embodiment of the thermal connector 10 depicted in FIG. 1). The "thermal aspect resistance" parameter may be defined as the thermal resistance divided by the aspect ratio. The "thermal aspect resistance" parameter value may be indicative of the effectiveness of the thermal connector 10 based on its size. For example, a low "thermal aspect resistance" may indicate that the thermal connector 10 not only has a low thermal resistance across the length of the thermal connector 10 but also that the thermal connector 10 has a reasonably high aspect ratio, such that it may span a reasonable length compared to its width. In some embodiments, the "thermal aspect resistance" parameter may be between about 2.2 C/W and about 4.3 C/W at about 22 °C. In some embodiments, the "thermal aspect resistance" parameter may be between about 2.2 C/W and about 3.0 C/W at about 22 °C. In some embodiments the "thermal aspect resistance" parameter may be between about 2.5 °C/W and about 4.1 °C/W at about 22 °C. In some embodiments the "thermal aspect resistance" parameter may be between about 2.5 C/W and about 3.2 °C/W at about 22 °C. In some embodiments the "thermal aspect resistance" parameter may be between about 3.9 °C/W and about 4.3 °C/W at about 22 °C.

As is known in the art, thermal resistivity and thermal conductivity of a material are inversely related. Thus, a low thermal resistivity correlates with a high thermal conductivity. In some embodiments, the electrically insulating beam 12 may be made from any suitable material having a generally low thermal resistivity (e.g., less than about 6.67 x 10⁻³ m•°C/W), and a generally high electrical resistivity (e.g., greater than about 10¹⁴ Ω•cm). A thermal resistivity of 6.67 x 10⁻³ m•°C/W is equivalent with a thermal conductivity of about 150 W/m•°C. In other words, suitable materials for the electrically insulating beam 12 may have a generally high thermal conductivity, such as greater than about 150 W/m•°C.

For example, in some embodiments, the electrically insulating beam 12 may be made from a material having a thermal conductivity between about 100 W/m•°C and about 300 W/m•°Cat about 22 °C. In other embodiments, the electrically insulating beam 12 may be made from a material having a thermal conductivity between about 125 W/m•°C and about 250 W/m•°Cat about 22 °C. In other embodiments, the electrically insulating beam 12 may be made from a material having a thermal conductivity between about 150 W/m•°Cand about 200 W/m•°C at about 22 °C.

In some embodiments, the electrically insulating beam 12 may comprise aluminum nitride, beryllium oxide, aluminum oxide, boron nitride, silicon nitride, magnesium oxide, zinc oxide, silicon carbide, any suitable ceramic material, and mixtures thereof.

In some embodiments, the electrically insulating beam 12 may comprise aluminum nitride. For example, in some embodiments the electrically insulating beam 12 may be made from any suitable composition including aluminum nitride. In some embodiments, the electrically insulating beam 12 may be made primarily from aluminum nitride. For example, the electrically insulating beam 12 may contain additives or impurities. In other embodiments, the electrically insulating beam 12 comprises beryllium oxide. For example, in some embodiments the electrically insulating beam 12 may be made from any suitable composition including beryllium oxide. In some embodiments, the electrically insulating beam 12 may be made primarily from beryllium oxide. For example, the electrically insulating beam 12 may contain additives or impurities.

In some embodiments, the terminals may include an outer layer over a substrate. The substrate may be magnetic in some embodiments, and non-magnetic in other embodiments. The outer layer may be formed from any suitable material, including, for example, corrosion-resistant materials. For example, in some embodiments, the terminals may comprise an outer layer of gold, silver, platinum, nickel, and/or a mixture or compound thereof. For example, in one embodiment, at least one of the first terminal 32 or the second terminal 34 may comprise gold. In some embodiments, at least one of the first terminal 32 or the second terminal 34 may comprise a magnetic material. In some embodiments, the magnetic material may be a substrate and the outer layer may be disposed over the magnetic material. For example, in one embodiment, one or more of the terminals may include an outer layer of gold disposed over a magnetic substrate, such as a magnetic or magnetized metal. In some embodiments, the substrate may comprise a metal such as copper or steel. In another embodiment, one of more of the terminals may include an outer layer, such as gold, disposed over a non-magnetic substrate, such as a ceramic, for example. In other embodiments, the outer layer may be gold, silver, platinum, nickel, copper, steel, and/or any other suitable material. Similarly, in other embodiments, the substrate may be gold, silver, platinum, nickel, copper, steel, and/or any other suitable material. Moreover, in some embodiments, the terminals may not include an outer layer.

In some embodiments, the thermal connector 10 may have a relatively low capacitance value. This may advantageously prevent substantial interference with electric fields, such as radio waves. For example, the thermal connector 10 may result in substantially no interference with the performance of electrical components to which the thermal connector 10 is connected, such as radio frequency amplifiers. For example, in some embodiments, the capacitance of the thermal connector 10 may be 0.2 pF or less. In some embodiments, the capacitance of the thermal connector 10 may be 0.15 pF or less. In some embodiments, the capacitance of the thermal connector 10 may be 0.13 pF or less. In some embodiments, the capacitance of the thermal connector 10 may be 0.10 pF or less. In some embodiments, the capacitance of the thermal connector 10 may be 0.08 pF or less. In some embodiments the capacitance of the thermal connector 10 may be 0.01 pF or greater. In some embodiments the capacitance of the thermal connector 10 may be 0.001 pF or greater.

The thermal connectors 10 may be manufactured or fabricated using any suitable technique. For example, the electrically insulating beam 12 may be cut from a substrate or wafer, and the terminals may then be formed on each electrically insulating beam 12. Alternatively, the terminals may be formed on a plate-shaped material and then the plate-shaped material may cut into the thermals connectors 10. The terminals may be formed using any suitable process, including, for example, chemical or vapor deposition on the electrically insulating beam 12. Alternatively, in some embodiments, the terminals may be formed by dipping the ends of the electrically insulating beam 12 in a liquid form of the terminal material and then allowing the terminal material to harden. The terminals may then be additionally shaped or finished using any suitable method, including for example, grinding or sanding. In some embodiments, the above process may be repeated to produce terminals having multiple layers, e.g., a gold plating over a magnetic or non-magnetic layer.

### IV. Connections

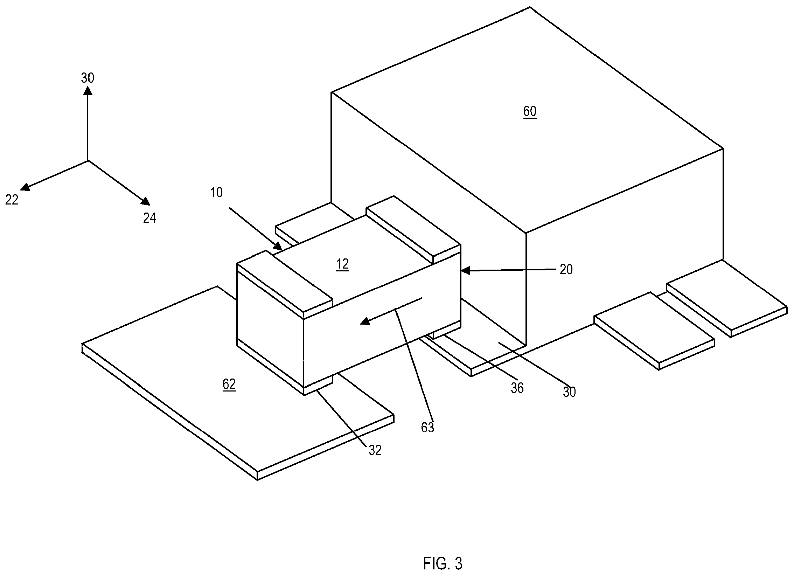

Referring to FIG. 3, in one embodiment, the thermal connector 10 may be directly connected between an electrical component 60 and a heat sink 62, or any other suitable component. For example, the third terminal 36 of the thermal connector 10 may be connected with an attachment tab 64 of the electrical component, and the first terminal 32 may be connected with the heat sink 62. Heat may flow from the attachment tab 64 of the electrical component 60, through the third terminal 36, through the electrically insulating beam 12, and out through the first terminal 32 to the heat sink 62 (as illustrated by the arrow 63).

In other embodiments, multiple thermal conductors may be connected in parallel or series to a single electrical component. For example, multiple thermal conductors may be connected in series, in an end-to-end configuration, to span a distance greater than the length of a single thermal conductor. Multiple thermal conductors may also be connected in parallel between a single electrical component and the heat sink, for example. In other embodiments, multiple heat sinks may be connected using multiple thermal connectors 10 to the electrical component.

Lastly, in some embodiments, the thermal connector 10 may connect a first electrical component with a second electrical component which may act as a heat sink. For example the second electrical component, while not itself a heat sink, may be connected with a heat sink such that heat may flow from the first electrical component, through the second electrical component, and into the heat sink. One of ordinary skill in the art would understand that still other configurations are possible based on the above disclosure.

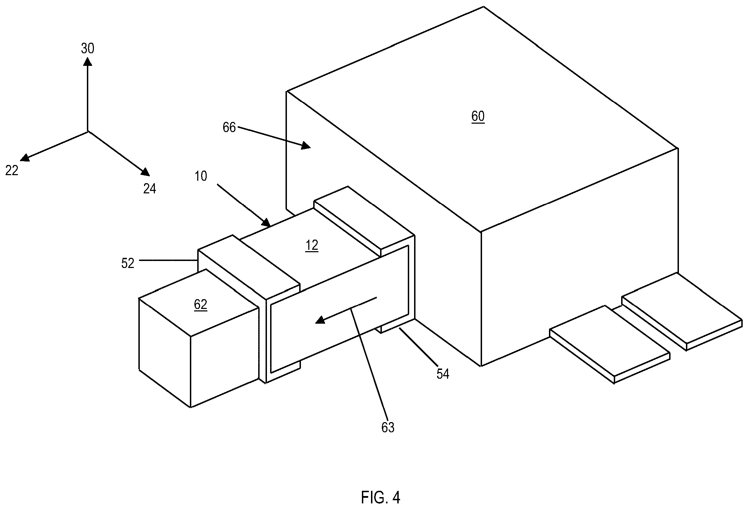

In some embodiments, the thermal connector 10 may be coupled directly to the electrical component, which may be particularly advantageous for electrical components lacking a suitable attachment tab 64. For example, the thermal connector 10 may directly thermally connect an electrical component 60 with the heat sink 62 as illustrated in FIG. 4. The thermal connector 10 illustrated in FIG. 4 has wrap-around terminals as illustrated in FIG. 2. The portion of the second wrap-around terminal 54 of the thermal connector 10 that extends over the second end 20 of the electrically insulating beam 12 may be directly attached to an exterior face 66 of the electrical component. Similarly, a portion of the first wrap-around terminal 52 that extends over the first end 16 of the electrically insulating beam 12 may be attached to a face of the heat sink 62. This configuration may advantageously provide a greater contact surface with at least one of the electrical component 60 or the heat sink 62.

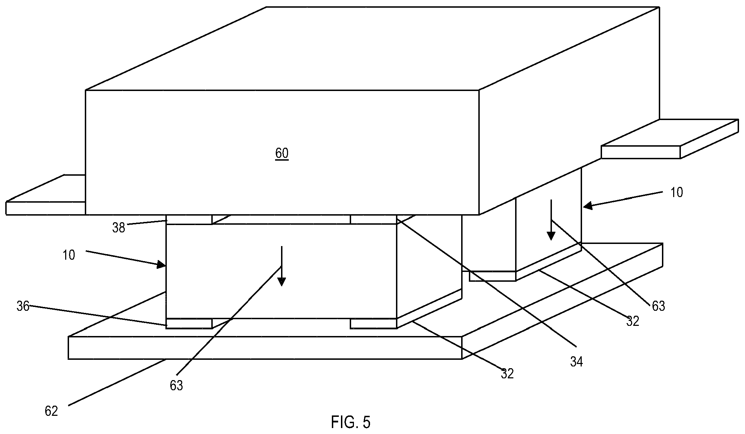

Referring to FIG. 5, in one embodiment, the electrical component 60 may be stacked on top of one or more thermal connectors 10 such that the second and fourth terminals 34, 38 are attached to the electrical component 60 and the first and third terminals 32, 36 are attached to the heat sink 62. Heat may flow (as illustrated by arrow 63) from the second and fourth terminals through the electrically insulating beam 12 and out through the first and third terminals 32, 36 to the heat sink 62.

The connections between the terminals and the electrical component 60 and/or heat sink 62 may be formed using any suitable method, such as soldering, for example. For example, the thermal connector 10 may be connected using an interconnect that attaches to or connects the respective terminals of the thermal connector 10. The interconnect may be made of a conductive material, such as a conductive metal. In one embodiment, the interconnect may be relatively flat or may be one having an increased surface area. Regarding the latter, the interconnect may have projections/protrusions or may also be formed from wires, braids, coils, etc. In this regard, the specific dimensions and configuration of the interconnects is not necessarily limited. Regardless of its form, any of a variety of different conductive materials may be employed, such as copper, tin, nickel, aluminum, etc., as well as alloys and/or coated metals. If desired, the conductive material may optionally be insulated with a sheath material.

### V. Electrical Tuning

In accordance with the present invention, the thermal connectors 10 include features that provide electrical tuning with the circuit and/or component to which the thermal connector 10 is connected. Such features can alter the radio frequency and/or microwave frequency response and/or characteristics of the thermal connector, for example to provide impedance matching.

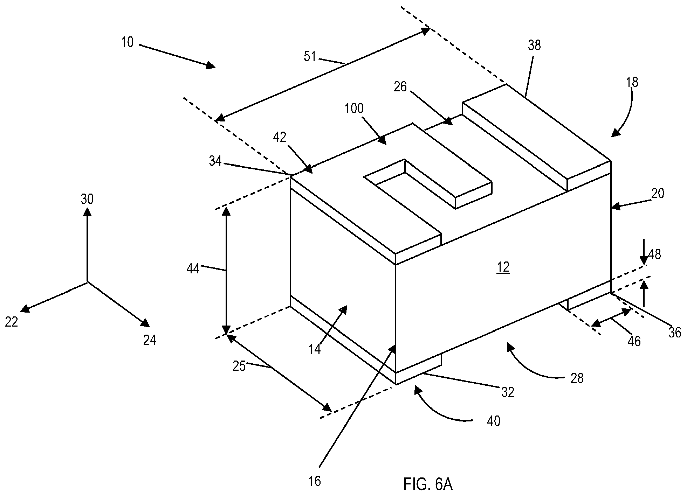

Referring to FIG. 6A, one or more conductive trace(s) 100 are formed on the top surface 26 of the thermal connector 10. The conductive trace(s) 100 may be formed from any suitable material and may have one or more layers, for example as described above with reference to the terminal materials and layer. For example, the conductive trace(s) 100 may include gold, silver, platinum, nickel, copper, steel, and/or any other suitable material.

The trace(s) 100 may be electrically connected (or integrally formed) with the second terminal 34. The trace(s) 100 may generally have an "L" shape that extends towards the fourth terminal 38. The size and dimensions of the trace(s) 100 may be selected to provide the desired electrical tuning effects.

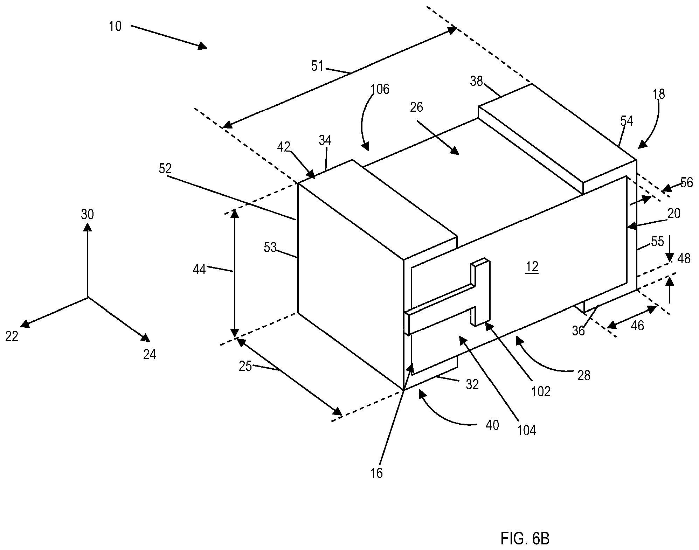

Referring to FIG. 6B, another embodiment of the thermal connector 10 is illustrated that includes a conductive trace 102 that is configured to provide electrical tuning (e.g., impedance matching). The conductive trace 102 may be formed on a side surface 104 of the thermal connector 10. A second side surface 106 may be parallel and opposite the side surface 104. The size and dimensions of the trace(s) 102 may be selected to provide the desired electrical tuning effects.

It should be understood that conductive trace(s) may be formed on any of the surfaces (e.g., bottom surface 40, top surface 42, first end face 14, second end face 18, and/or one or both of the side surfaces 104, 106) of the thermal connector 10. Furthermore, the trace(s) may be electrically connected with any of the terminals (e.g., first terminal 32, second terminal 34, third terminal 36, and/or fourth terminal 38) of the thermal connector 10. However, the conductive traces generally are not connected in a way that would facilitate electrical flow between the heat source and heat sink. In addition, the conductive traces may be physically located between two or more of the terminals 32, 34, 36, 38.

The number, size, and shape of such traces can be selected to provide one or more desired electrical tuning characteristics (e.g., impedance, resonance frequency, insertion loss, return loss, etc.). As such, the traces may have a variety of suitable shapes and geometries that can be selected to electrically tune the thermal connector 10. As examples, the trace(s) may have an "L" or "T" shape. Similarly, the number of traces can vary, for example between 1 and 10, or more.

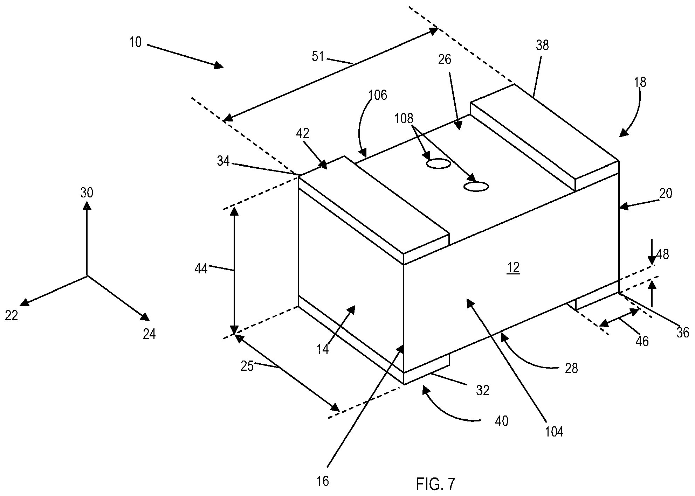

Referring to FIG. 7, in some embodiments, one or more holes 108 may be formed in the electrically insulating beam 12 and/or terminals (e.g., first terminal 32, second terminal 34, third terminal 36, and/or fourth terminal 38) of the thermal connector 10 to electrically tune the thermal connector 10. Such holes 108 may be formed using a variety of suitable techniques, including laser drilling. A size and/or number of such holes 108 may be selected to electrically tune the thermal connector 10, for example, to provide impedance matching. Referring to FIG. 7, a pair of holes 108 may extend from the top face 26 to the bottom face 28 of the thermal connector 10. In other embodiments, holes may extend between side surfaces 102, 104 or between end faces 14, 20. Additionally, any suitable number of holes may be provided, including, for example from 1 to 10, or more.

### VI. Applications

The various embodiments of thermal connectors 10 disclosed herein may be connected between any suitable heat source and sink. For example, the thermal connector 10 may be connected to a heat source, such as a terminal pad or conductive trace, and connected to a grounded cover or thermal via. The thermal via may be formed in a layer of a printed circuit board and may connect with a heat sink. For instance, the thermal connector 10 may be connected with the thermal via on a first surface of the layer, and the thermal via may extend through the layer to connect with a heat sink that is located on a second surface that is opposite the first surface.

The thermal connector 10 may also be connected between terminals of a transistor (e.g., MOSFET). For example, the thermal connector 10 may be connected between gate and ground terminals. As another example, the thermal connector 10 may be connected between source and ground terminals.

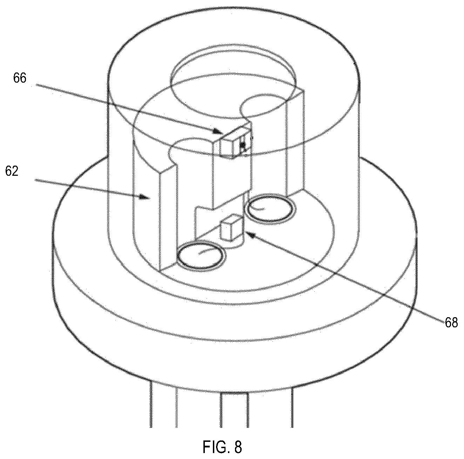

The various embodiments of thermal connectors 10 disclosed herein may find application with any suitable electrical component, such as a power amplifier, filter, synthesizer, computer component, power supply, and/or diode, for example. Specific examples of power amplifier types include Gallium Nitride (GaN) power amplifiers, high radio frequency amplifiers, and the like. Examples of diodes which may be suitable for connection with a thermal component, as described herein, may include diodes specifically adapted for use in lasers, among other types of diodes. For example, referring to FIG. 8, in some embodiments, the thermal connector 10 may be used to form or improve a thermal connection between a laser diode 66 and a heat sink 62. In some embodiments, the thermal connector 10 may be used to form or improve a thermal connection between a monitor photodiode 68 and the heat sink 62.

### EXAMPLE

The following table shows dimensions and thermal properties for various exemplary embodiments in accordance with aspects of the present invention. 1 inch (in) = 25.4 mm.

**Table 1: Examples of Thermal Connector Embodiments**

| | | | | **Thermal Resistance (C / W)** | | **Thermal Conductivity (mW / C)** | |
|---|---|---|---|---|---|---|---|
| **Case Size** | **Length (in)** | **Width (in)** | **Thickness (in)** | **AIN** | **BeO** | **AIN** | **BeO** |
| 2010 | 0.195 | 0.095 | 0.06 | 10 | 6 | 100 | 159 |
| 2525 | 0.24 | 0.25 | 0.06 | 4 | 3 | 240 | 380 |
| 3737 | 0.365 | 0.375 | 0.06 | 4 | 3 | 240 | 380 |
| 3725 | 0.37 | 0.245 | 0.06 | 6 | 4 | 160 | 254 |

## Claims

1. A thermal connector (10) comprising:
an electrically insulating beam (12) having a first end face (14) at a first end (16) and a second end face (18) at a second end (20), the second end face opposite the first end face in an X direction (22), the electrically insulating beam having a width in a Y directior (24) perpendicular to the X direction, the electrically insulating beam having a top face (26) and a bottom face (28) which is offset from the top face in a Z direction (30), the Z direction being perpendicular to each of the X and Y directions;
a first terminal (32) attached to the bottom face and adjacent the first end;
a second terminal (34) attached to the top face and adjacent the first end; **characterised by**
a conductive trace (100) formed on an outer surface of the electrically insulating beam and configured to provide electrical tuning.

2. The thermal connector of claim 1, wherein the electrically insulating beam comprises a material having a thermal conductivity from about 150 W/m•°C to about 300 W/m•°C at about 22 °C.

3. The thermal connector of claim 1, wherein the electrically insulating beam comprises at least one of aluminum nitride or beryllium oxide.

4. The thermal connector of claim 1, further comprising:
a third terminal (36) attached to the bottom face and adjacent the second end and
a fourth terminal (38) attached to the top face and adjacent the second end

5. The thermal connector of claim 4, further including:
a first end face terminal (53) attached to the first end face of the electrically insulating beam and connecting the first terminal with the second terminal; and
a second end face terminal attached to the second end face of the electrically insulating beam and connecting the third terminal with the fourth terminal.

6. The thermal connector of claim 1, wherein an overall length of the thermal connector is between about 2.5 mm and about 12.7 mm, wherein an overall width of the thermal connector is between about 5.1 mm and about 10.2 mm, and wherein an overall thickness of the thermal connector in the Z direction, including the first and second terminals, is greater than 1.27 mm and less than 3.81 mm.

7. The thermal connector of claim 1, wherein at least one of the first terminal or the second terminal comprises gold or a magnetized material.

8. The thermal connector of claim 1, wherein the thermal connector has a thermal aspect resistance parameter between about 2.2 °C/W and about 3.0 °C/W at about 22 °C, and wherein the thermal aspect resistance parameter is a ratio of an aspect ratio of the thermal connector divided by a thermal resistance of the thermal connector, and wherein the aspect ratio is an overall length of the thermal connector divided by an overall width of the thermal connector.

9. The thermal connector of claim 1, wherein at least one hole is formed in the electrically insulating beam to provide electrical tuning.

10. The thermal connector of claim 1, wherein the thermal connector extends between a heat source and a heat sink, and wherein the conductive trace is electrically connected with at least one of the first terminal and the second terminal such that electrical flow is prevented between the heat source and the heat sink.

11. The thermal connector of claim 1, wherein the conductive trace is connected with one of the first terminal or the second terminal, and wherein the conductive trace has an L shape or a T shape.

12. A thermal connector comprising:
an electrically insulating beam having a first end face at a first end and a second end face at a second end, the second end face opposite the first end face in an X direction, the electrically insulating beam having a width in a Y direction perpendicular to the X direction, the electrically insulating beam having a top face and a bottom face which is offset from the top face in a Z direction, the Z direction being perpendicular to each of the X and Y directions;
a first terminal attached to the bottom face and adjacent the first end;
a second terminal attached to the top face and adjacent the first end; **characterised by**
at least one hole formed in the electrically insulating beam, the at least one hole configured to provide electrical tuning.

13. The thermal connector of claim 12, wherein the at least one hole is a pair of holes extending from the top face to the bottom face of the electrically insulating beam.

14. The thermal connector of claim 12, wherein the at least one hole is a pair of holes extending between the first end face and the second end face of the electrically insulating beam or between side surfaces of the electrically insulating beam.

15. The thermal connector of claim 12, wherein the electrically insulating beam comprises at least one of aluminum nitride or beryllium oxide.

## Patentansprüche

1. Thermischer Verbinder (10), umfassend:
einen elektrisch isolierenden Träger (12), der eine erste Endfläche (14) an einem ersten Ende (16) und eine zweite Endfläche (18) an einem zweiten Ende (20) aufweist, wobei die zweite Endfläche der ersten Endfläche in einer X-Richtung (22) entgegengesetzt ist, wobei der elektrisch isolierende Träger eine Breite in einer Y-Richtung (24), die senkrecht zu der X-Richtung steht, aufweist, wobei der elektrisch isolierende Träger eine obere Fläche (26) und eine untere Fläche (28), die in einer Z-Richtung (30) gegenüber der oberen Fläche versetzt ist, aufweist, wobei die Z-Richtung jeweils senkrecht auf der X- und auf der Y-Richtung steht;
einen ersten Anschluss (32), der an der unteren Fläche befestigt ist und an das erste Ende angrenzt;
einen zweiten Anschluss (34), der an der oberen Fläche befestigt ist und an das erste Ende angrenzt; **gekennzeichnet durch**
eine Leiterbahn (100), die auf einer äußeren Fläche des elektrisch isolierenden Trägers ausgebildet und so konfiguriert ist, dass sie eine elektrische Abstimmung ermöglicht.

2. Thermischer Verbinder gemäß Anspruch 1, wobei der elektrisch isolierende Träger ein Material umfasst, das eine Wärmeleitfähigkeit von etwa 150 W/m•°C bis etwa 300 W/m•°C bei etwa 22 °C aufweist.

3. Thermischer Verbinder gemäß Anspruch 1, wobei der elektrisch isolierende Träger Aluminiumnitrid und/oder Berylliumoxid umfasst.

4. Thermischer Verbinder gemäß Anspruch 1, ferner umfassend:
einen dritten Anschluss (36), der an der unteren Fläche befestigt ist und an das zweite Ende angrenzt; und
einen vierten Anschluss (38), der an der oberen Fläche befestigt ist und an das zweite Ende angrenzt.

5. Thermischer Verbinder gemäß Anspruch 4, weiterhin umfassend:
einen ersten Endflächenanschluss (53), der an der ersten Endfläche des elektrisch isolierenden Trägers befestigt ist und den ersten Anschluss mit dem zweiten Anschluss verbindet; und
einen zweiten Endflächenanschluss, der an der zweiten Endfläche des elektrisch isolierenden Trägers befestigt ist und den dritten Anschluss mit dem vierten Anschluss verbindet.

6. Thermischer Verbinder gemäß Anspruch 1, wobei die Gesamtlänge des thermischen Verbinders zwischen etwa 2,5 mm und etwa 12,7 mm liegt, wobei die Gesamtbreite des thermischen Verbinders zwischen etwa 5,1 mm und etwa 10,2 mm liegt und wobei die Gesamtdicke des thermischen Verbinders in der Z-Richtung einschließlich des ersten und des zweiten Anschlusses größer als 1,27 mm und kleiner als 3,81 mm ist.

7. Thermischer Verbinder gemäß Anspruch 1, wobei der erste Anschluss und/oder der zweite Anschluss Gold oder ein magnetisiertes Material umfasst.

8. Thermischer Verbinder gemäß Anspruch 1, wobei der thermische Verbinder einen Wärmewiderstands-Formparameter zwischen etwa 2,2 °C/W und etwa 3,0 °C/W bei etwa 22 °C aufweist und wobei der Wärmewiderstands-Formparameter ein Verhältnis des Aspektverhältnisses des thermischen Verbinders, dividiert durch den Wärmewiderstand des thermischen Verbinders, ist und wobei das Aspektverhältnis die Gesamtlänge des thermischen Verbinders, dividiert durch die Gesamtbreite des thermischen Verbinders, ist.

9. Thermischer Verbinder gemäß Anspruch 1, wobei in dem elektrisch isolierenden Träger wenigstens ein Loch ausgebildet ist, um eine elektrische Abstimmung zu ermöglichen.

10. Thermischer Verbinder gemäß Anspruch 1, wobei sich der thermische Verbinder zwischen einer Wärmequelle und einer Wärmesenke erstreckt und wobei die Leiterbahn elektrisch mit dem ersten Anschluss und/oder dem zweiten Anschluss so verbunden ist, dass ein Fließen von elektrischem Strom zwischen der Wärmequelle und der Wärmesenke verhindert wird.

11. Thermischer Verbinder gemäß Anspruch 1, wobei die Leiterbahn mit dem ersten Anschluss oder dem zweiten Anschluss verbunden ist und wobei die Leiterbahn eine L-Form oder eine T-Form aufweist.

12. Thermischer Verbinder, umfassend:
einen elektrisch isolierenden Träger, der eine erste Endfläche an einem ersten Ende und eine zweite Endfläche an einem zweiten Ende aufweist, wobei die zweite Endfläche der ersten Endfläche in einer X-Richtung entgegengesetzt ist, wobei der elektrisch isolierende Träger eine Breite in einer Y-Richtung, die senkrecht zu der X-Richtung steht, aufweist, wobei der elektrisch isolierende Träger eine obere Fläche und eine untere Fläche, die in einer Z-Richtung gegenüber der oberen Fläche versetzt ist, aufweist, wobei die Z-Richtung jeweils senkrecht auf der X- und auf der Y-Richtung steht;
einen ersten Anschluss, der an der unteren Fläche befestigt ist und an das erste Ende angrenzt;
einen zweiten Anschluss, der an der oberen Fläche befestigt ist und an das erste Ende angrenzt; **gekennzeichnet durch**
wenigstens ein Loch, das in dem elektrisch isolierenden Träger ausgebildet ist, wobei das wenigstens eine Loch so konfiguriert ist, dass es eine elektrische Abstimmung ermöglicht.

13. Thermischer Verbinder gemäß Anspruch 12, wobei es sich bei dem wenigstens einen Loch um ein Paar von Löchern handelt, die sich von der oberen Fläche zur unteren Fläche des elektrisch isolierenden Trägers erstrecken.

14. Thermischer Verbinder gemäß Anspruch 12, wobei es sich bei dem wenigstens einen Loch um ein Paar von Löchern handelt, die sich zwischen der ersten Endfläche und der zweiten Endfläche des elektrisch isolierenden Trägers oder zwischen Seitenflächen des elektrisch isolierenden Trägers erstrecken.

15. Thermischer Verbinder gemäß Anspruch 12, wobei der elektrisch isolierende Träger Aluminiumnitrid und/oder Berylliumoxid umfasst.

## Revendications

1. Connecteur thermique (10), comprenant :
une poutre électriquement isolante (12) ayant une première face d'extrémité (14) à une première extrémité (16) et une deuxième face d'extrémité (18) à une deuxième extrémité (20), ladite deuxième face d'extrémité étant opposée à ladite première face d'extrémité dans une direction X (22), ladite poutre électriquement isolante ayant une largeur dans une direction Y (24) perpendiculaire à ladite direction X, ladite poutre électriquement isolante ayant une surface supérieure (26) et une surface inférieure (28), qui est décalée par rapport à ladite surface supérieure dans une direction Z (30), ladite direction Z étant perpendiculaire à chacune des directions X et Y ;
un premier raccordement (32) attaché à ladite surface inférieure et adjacent à ladite première extrémité ;
un deuxième raccordement (34) attaché à ladite surface supérieure et adjacent à ladite première extrémité ; **caractérisé par**
une piste conductrice (100) formée sur une surface extérieure de la poutre électriquement isolante et configurée pour fournir un accord électrique.

2. Connecteur thermique selon la revendication 1, dans lequel ladite poutre électriquement isolante comprend un matériau ayant une conductivité thermique allant d'environ 150 W/m•°C à environ 300 W/m•°C à environ 22 °C.

3. Connecteur thermique selon la revendication 1, dans lequel la poutre électriquement isolante comprend le nitrure d'aluminium et/ou l'oxyde de béryllium.

4. Connecteur thermique selon la revendication 1, comprenant en outre :
un troisième raccordement (36) attaché à ladite surface inférieure et adjacent à ladite deuxième extrémité ; et
un quatrième raccordement (38) attaché à ladite surface supérieure et adjacent à ladite deuxième extrémité.

5. Connecteur thermique selon la revendication 4, comprenant en outre :
un raccordement de la première face d'extrémité (53) attaché à la première face d'extrémité de la poutre électriquement isolante et reliant le premier raccordement au deuxième raccordement ; et
un raccordement de la deuxième face d'extrémité attaché à la deuxième face d'extrémité de la poutre électriquement isolante et reliant le troisième raccordement au quatrième raccordement.

6. Connecteur thermique selon la revendication 1, dans lequel la longueur totale du connecteur thermique est comprise entre environ 2,5 mm et environ 12,7 mm, dans lequel la largeur totale du connecteur thermique est comprise entre environ 5,1 mm et environ 10,2 mm, et dans lequel l'épaisseur totale du connecteur thermique dans la direction Z incluant les premier et deuxième raccordements est supérieure à 1,27 mm et inférieure à 3,81 mm.

7. Connecteur thermique selon la revendication 1, dans lequel au moins l'un parmi le premier raccordement et le deuxième raccordement comprend de l'or ou un matériau magnétisé.

8. Connecteur thermique selon la revendication 1, dans lequel le connecteur thermique présente un paramètre de forme de la résistance thermique compris entre environ 2,2 °C/W et environ 3,0 °C/W à environ 22 °C, et dans lequel ledit paramètre de forme de la résistance thermique est un rapport d'un rapport d'aspect du connecteur thermique, divisé par la résistance thermique du connecteur thermique, et dans lequel le rapport d'aspect est une longueur totale du connecteur thermique, divisée par une largeur totale du connecteur thermique.

9. Connecteur thermique selon la revendication 1, dans lequel au moins un trou est formé dans la poutre électriquement isolante pour fournir un accord électrique.

10. Connecteur thermique selon la revendication 1, dans lequel le connecteur thermique s'étend entre une source de chaleur et un puits de chaleur, et dans lequel la piste conductrice est électriquement raccordée à au moins l'un parmi le premier raccordement et le deuxième raccordement de telle manière qu'un flux de courant électrique soit empêché entre ladite source de chaleur et ledit puits de chaleur.

11. Connecteur thermique selon la revendication 1, dans lequel la piste conductrice est raccordée à l'un parmi le premier raccordement et le deuxième raccordement, et dans lequel ladite piste conductrice présente une forme L ou une forme T.

12. Connecteur thermique, comprenant :
une poutre électriquement isolante ayant une première face d'extrémité à une première extrémité et une deuxième face d'extrémité à une deuxième extrémité, ladite deuxième face d'extrémité étant opposée à ladite première face d'extrémité dans une direction X, ladite poutre électriquement isolante ayant une largeur dans une direction Y perpendiculaire à ladite direction X, ladite poutre électriquement isolante ayant une surface supérieure et une surface inférieure qui est décalée par rapport à ladite surface supérieure dans une direction Z, ladite direction Z étant perpendiculaire à chacune des directions X et Y ;
un premier raccordement attaché à ladite surface inférieure et adjacent à ladite première extrémité ;
un deuxième raccordement attaché à ladite surface supérieure et adjacent à ladite première extrémité ; **caractérisé par**
au moins un trou formé dans la poutre électriquement isolante, ledit au moins un trou étant configuré pour fournir un accord électrique.

13. Connecteur thermique selon la revendication 12, dans lequel ledit au moins un trou est une paire de trous s'étendant de la surface supérieure à la surface inférieure de la poutre électriquement isolante.

14. Connecteur thermique selon la revendication 12, dans lequel ledit au moins un trou est une paire de trous s'étendant entre la première face d'extrémité et la deuxième face d'extrémité de la poutre électriquement isolante ou entre des surfaces latérales de la poutre électriquement isolante.

15. Connecteur thermique selon la revendication 12, dans lequel la poutre électriquement isolante comprend le nitrure d'aluminium et/ou l'oxyde de béryllium.
